# EUROPÄISCHE PATENTSCHRIFT

(11) **EP 3 385 623 B1**
(45) Veröffentlichungstag und Bekanntmachung des Hinweises auf die Patenterteilung: **12.10.2022**
(21) Anmeldenummer: 18168398.8
(22) Anmeldetag: 26.08.2006
(51) Int. Cl.: F24C 7/08, H03K 17/96

(54) **HERD MIT EINER BEDIEN- UND ANZEIGEEINHEIT**
COOKING RANGE WITH A COMMAND AND DISPLAY UNIT
PLAQUE DE CUISSON AVEC UNE UNITÉ DE COMMANDE ET DE SIGNALISATION

(43) Veröffentlichungstag der Anmeldung: 10.10.2018
(62) Teilanmeldung aus: 06017847.2
(73) Patentinhaber: Electrolux Home Products Corporation N.V., 1130 Brussels (BE)
(72) Erfinder: LEIKAM, Juergen, 91541 Rothenburg ob der Tauber (DE); HOLZINGER, Jochen, 91541 Rothenburg ob der Tauber (DE); MEIDER, Claus, 91541 Rothenburg ob der Tauber (DE); BUSCH, Andreas, 91541 Rothenburg ob der Tauber (DE)

(56) Entgegenhaltungen:
- EP-A- 1 662 207
- EP-A- 1 672 797
- DE-A1- 10 133 135
- DE-A1- 10 236 718
- DE-A1-102004 058 478
- DE-U1- 20 119 700
- DE-U1-202005 007 480
- US-B1- 6 329 646

## Beschreibung

Die Erfindung betrifft einen Herd mit einer Vorrichtung für ein Haushaltsgerät, welche wenigstens ein Bedienelement und wenigstens ein Anzeigeelement aufweist.

Haushaltsgeräte verschiedenster Art, beispielsweise Herde, Mikrowellengeräte, Waschmaschinen, Wäschetrockner etc., verfügen in der Regel über eine Bedieneinheit und eine Anzeigeeinheit. Mit Hilfe der Bedieneinheit kann ein Benutzer das Haushaltsgerät bedienen. Mit Hilfe der Anzeigeeinheit können einem Benutzer insbesondere Betriebszustände und Betriebsparameter des Haushaltsgerätes angezeigt werden. Die Bedieneinheit und die Anzeigeeinheit können auch miteinander zu einer Bedien- und Anzeigeeinheit kombiniert sein. Die Bedien- und Anzeigeeinheit stellt eine Komponente des Haushaltsgerätes dar.

Eine Bedien- und Anzeigeeinheit, beispielsweise für einen Herd, umfasst zumeist eine Platine mit Leiterbahnen, auf der elektrisch miteinander verbundene Standardkomponenten, beispielsweise Infrarot-Sensoren, kapazitive Sensoren, Sieben-Segmentanzeigen, LEDs (Light emitting diodes) mit Kunststoffabdeckungen etc. angeordnet sind. Eine derartige Platine einer Bedien- und Anzeigeeinheit ist in der Regel unterhalb einer Glaskeramik des Herdes angeordnet. Um eine störungsfreie Bedienung des Herdes mittels der Bedien- und Anzeigeeinheit sicherzustellen, müssen insbesondere die von einem Benutzer im Zuge der Bedienung betätigbaren kapazitiven Sensoren an die untere Oberfläche der Glaskeramik gebracht werden, was mit Hilfe von Federn, leitendem Gummi, beispielsweise der Firma EGO, oder durch Kunststoffträger bewerkstelligt werden kann.

Des Weiteren ist es gängige Praxis, die Bedien- und Anzeigeeinheit, insbesondere die kapazitiven Sensoren, direkt mittels eines doppelseitigen Klebebandes an die untere Oberfläche der Glaskeramik zu kleben. Auf diese Weise befinden sich sowohl die kapazitiven Sensoren als auch die LEDs, Sieben-Segmentanzeigen oder andere optische Anzeigen, dicht oder direkt unter der Glaskeramik und ermöglichen eine Bedienung des Haushaltsgerätes sowie ein Ablesen von Betriebszuständen und Betriebsparametern des Haushaltsgerätes.

Als nachteilig hat sich der verhältnismäßig aufwändige Aufbau derartiger Bedien- und Anzeigeeinheiten, insbesondere die Anordnung von Bedien- und Anzeigeelementen nebeneinander, erwiesen.

In der DE 201 19 700 U1 ist eine Sensorvorrichtung zur Erzeugung eines Schaltsignals beschrieben. Das Schaltsignal wird durch Annäherung und/oder Berührung eines kapazitiven Sensorelements mit dem Finger ausgelöst. Das Sensorelement ist an der Oberseite eines Trägerelements angeordnet. Die Oberseite mit dem Sensorelement ist von einer Blende aus einem durchsichtigen Material abgedeckt. An der Unterseite des Trägerelements befindet sich eine Leiterplatte mit einem Leuchtmittel. Das Leuchtmittel ist innerhalb einer Durchgangsöffnung des Trägerelements angeordnet, so dass das Licht durch die Blende nach Außen treten kann.

Aus der EP 1 724 088 A1 ist ein Anzeige- und Bedienungspaneel für Haushaltsgeräte mit einer verformten Blendenfront bekannt, in der Anzeige- und Bedienungsbereiche angeordnet sind. Ein Blendenkörper und eine Blendenfront bilden zusammen eine Trägerstruktur, hinter welcher Bedien- und Anzeigeelemente, zum Teil in entsprechenden Aussparungen, angeordnet sind.

Aus der EP 1 662 207 A1 ist eine Bedienvorrichtung für ein elektrisches Haushaltsgerät. Das Dokument offenbart weiterhin einen Träger mit Aussparungen, in denen mechanische Betätigungselemente und optische Anzeigeelemente angeordnet sind.

Der Erfindung liegt daher die Aufgabe zugrunde, einen Herd mit einer Vorrichtung der eingangs genannten Art möglichst einfach auszubilden.

Nach der Erfindung wird diese Aufgabe gelöst durch einen Herd mit einer Bedien- und Anzeigeeinheit mit den Merkmalen des Anspruchs 1. Eine Vorrichtung, hier Bedien- und Anzeigeeinheit, umfasst ein eine Oberseite und eine Unterseite umfassendes Trägerelement, eine wenigstens ein Bedienelement aufweisendee Bedieneinrichtung und eine wenigstens ein Anzeigeelement aufweisende Anzeigeeinrichtung, wobei das Trägerelement auf seiner Unterseite wenigstens eine erste Aussparung aufweist, wobei die Bedieneinrichtung auf der Oberseite des Trägerelementes und die Anzeigeeinrichtung zumindest teilweise in der ersten Aussparung auf der Unterseite des Trägerelementes angeordnet ist. Erfindungsgemäß erfolgt demnach eine Trennung von Bedieneinrichtung und Anzeigeeinrichtung, wobei die Bedieneinrichtung an der Oberseite des Trägerelementes und die Anzeigeeinrichtung auf der Unterseite des Trägerelementes angeordnet sind. Die Anzeigeeinrichtung kann in raumsparender, vorteilhafter Weise zumindest teilweise in einer ersten Aussparung auf der Unterseite des Trägerelementes angeordnet werden. In der Regel weist das Trägerelement mehrere erste Aussparungen auf, in denen bevorzugt jeweils wenigstens ein Anzeigeelement der Anzeigeeinrichtung aufgenommen bzw. angeordnet werden kann. Die Struktur des Trägerelementes auf der Unterseite ist demnach bevorzugt an die Anzeigeeinrichtung, insbesondere an die Anordnung von Anzeigeelementen auf der Anzeigeeinrichtung, angepasst, so dass bevorzugt jedes Anzeigeelement der Anzeigeeinrichtung bei Anordnung der Anzeigeeinrichtung an der Unterseite des Trägerelementes in einer ersten Aussparung des Trägerelementes angeordnet wird. Auf diese Weise wird ein einfacher und kompakter Aufbau der Vorrichtung erreicht.

Nach der Erfindung weist das Trägerelement auch auf seiner Oberseite wenigstens eine Aussparung auf, welche als zweite Aussparung zur Unterscheidung von der bzw. den ersten Aussparungen auf der Unterseite des Trägerelementes bezeichnet wird. Die zweite Aussparung ist bevorzugt als zweite Vertiefung ausgeführt. Die Bedieneinrichtung ist dabei zumindest teilweise in der zweiten Aussparung auf der Oberseite des Trägerelementes angeordnet. Dadurch ergibt sich nochmals eine Verbesserung des kompakten Aufbaus der Vorrichtung, so dass die Vorrichtung in ihrer Tiefe nur gering aufbaut.

Eine Variante der Erfindung sieht vor, dass das Trägerelement ein im Wesentlichen lichtundurchlässiges und/oder temperaturbeständiges Material aufweist. Bevorzugt ist das Trägerelement zumindest teilweise aus diesem lichtundurchlässigen und/oder temperaturbeständigen Material aufgebaut. Dadurch kann das Trägerelement eine Doppelfunktion erfüllen, da es einerseits unter Berücksichtigung der an der Unterseite des Trägerelementes angeordneten Anzeigeeinrichtung für diese eine Art Lichtmaske ist. Zugleich dient das Trägerelement, wie bereits der Bezeichnung "Trägerelement" zu entnehmen ist, als Träger der Bedieneinrichtung als auch der Anzeigeeinrichtung.

Eine Ausführungsform der Erfindung sieht vor, dass das Trägerelement ein zweites, im Wesentlichen lichtdurchlässiges Material aufweist.

Nach einer Ausführungsform der Erfindung ist die erste Aussparung des Trägerelementes als Durchgangsöffnung oder erste Vertiefung auf der Unterseite des Trägerelementes ausgebildet. Nach einer Variante der Erfindung kann zum Erhalt der ersten Vertiefung auf der Unterseite des Trägerelementes die Durchgangsöffnung mit dem zweiten lichtdurchlässigen Material verschlossen und/oder zumindest teilweise ausgefüllt sein.

Das Trägerelement weist wenigstens eine Durchgangsöffnung oder erste Vertiefung, in der Regel mehrere Durchgangsöffnungen oder erste Vertiefungen auf, in denen, wie bereits erwähnt, bevorzugt jeweils wenigstens ein Anzeigeelement angeordnet werden kann, so dass das von einem Anzeigeelement ausgehende Licht sei es durch die Durchgangsöffnung oder die mit dem lichtdurchlässigen Material versehene erste Vertiefung durch das Trägerelement hindurchtreten kann.

Nach einer Ausführungsform der Erfindung ist die Durchgangsöffnung zur Bildung der ersten Vertiefung derart mit dem zweiten Material verschlossen und/oder zumindest teilweise ausgefüllt, dass sich auf der Oberseite des Trägerelementes im Bereich der Durchgangsöffnung eine im Wesentlichen plane Teiloberfläche und dass sich auf der Unterseite des Trägerelementes eine erste Aussparung in Form der ersten Vertiefung ergibt. Weist also das Trägerelement mehrere derartige Durchgangsöffnungen auf, welche auf der Oberseite des Trägerelementes mit dem zweiten Material verschlossen und/oder zumindest teilweise ausgefüllt sind, so ergeben sich mehrere erste Vertiefungen auf der Unterseite des Trägerelementes, in denen, wie bereits erwähnt, jeweils ein Anzeigeelement der Anzeigeeinrichtung angeordnet werden kann. Dadurch, dass das zweite Material des Trägerelementes im Wesentlichen lichtdurchlässig ist, kann demnach ein von einem Anzeigeelement ausgehendes Licht durch das Trägerelement hindurchtreten.

Nach Varianten der Erfindung handelt es sich bei dem ersten und/oder bei dem zweiten Material jeweils um einen Kunststoff. Bevorzugt handelt es sich bei dem zweiten Material um ein lichtzerstreuendes Material oder um einen lichtzerstreuenden Kunststoff oder explizit um ein Epoxidharz. Durch das lichtzerstreuende Material ergibt sich eine gleichmäßige Ausleuchtung der ersten Vertiefung, wenn man das Trägerelement im Bereich der jeweiligen ersten Aussparung bzw. ersten Vertiefung von der Oberseite her betrachtet.

Nach einer Variante der Erfindung weist die Bedieneinrichtung eine Platine, eine Folie oder einen Bedienelementträger auf, welche jeweils wenigstens ein Bedienelement umfassen. Die zweite Aussparung auf der Oberseite des Trägerelementes ist bevorzugt an die Form der Platine, der Folie oder des Bedienelementträgers angepasst, so dass die Platine, die Folie oder der Bedienelementträger bevorzugt passgenau zumindest teilweise in der zweiten Aussparung auf der Oberseite des Trägerelementes aufgenommen werden kann. Die Bedieneinrichtung ist in der Regel dabei derart ausgestaltet, dass sie an den Stellen Ausschnitte aufweist, an denen Licht von Anzeigeelementen der Anzeigeeinrichtung das Trägerelement im Bereich der ersten Aussparungen durchdringt bzw. durchdringen soll. Die Bedieneinrichtung überdeckt also die den ersten Aussparungen zugeordneten Oberflächen auf der Oberseite des Trägerelementes nicht.

Die Platine oder die Folie oder der Bedienelementträger weist wenigstens eine Leiterbahn und/oder wenigstens eine Kupferfläche auf. In der Regel weist die Platine oder die Folie oder der Bedienelementträger mehrere Leiterbahnen oder Kupferflächen auf. Als Bedienelement umfasst die Bedieneinrichtung wenigstens einen Sensor, beispielsweise einen kapazitiven Sensor oder kapazitiven Tastsensor, durch dessen Betätigung Bedieneingaben möglich sind.

Die Anzeigeeinrichtung weist eine wenigstens ein Anzeigeelement umfassende Platine oder einen wenigstens ein Anzeigeelement umfassenden Anzeigeelementträger auf. Die Platine oder der Anzeigeelementträger weist wenigstens eine Leiterbahn, in der Regel mehrere Leiterbahnen, auf. Bei den Anzeigeelementen der Anzeigeeinrichtung handelt es sich bevorzugt um Leuchtelemente, beispielsweise LEDs oder Sieben-Segmentanzeigen, welche ebenfalls aus LEDs aufgebaut sein können.

Die Anzeigeeinrichtung und die Bedieneinrichtung sind in der Regel elektrisch miteinander verbunden, wobei die elektrische Verbindung beispielsweise mittels eines Folienleiters oder mittels wenigstens einer Kontaktbuchse und wenigstens einem Kontaktstift erfolgen kann.

Nach einer Ausführungsform der Erfindung bilden das Trägerelement, die Bedieneinrichtung und die Anzeigeeinrichtung eine Einheit, wobei das Trägerelement, die Bedieneinrichtung und die Anzeigeeinrichtung fest, bevorzugt aber lösbar, miteinander verbunden sind. Die Verbindung kann allerdings auch nichtlösbar ausgeführt sein. Bevorzugt erfolgt die Verbindung von Trägerelement, Bedieneinrichtung und Anzeigeeinrichtung mittels Rastverbindung, Ultraschallverschweißung und/oder Verkleben.

Nach einer Variante der Erfindung ist auf der Oberseite des Trägerelementes und/oder der Bedieneinrichtung eine wenigstens ein Symbol aufweisende, zumindest teilweise lichtdurchlässige Folie angeordnet. Bei den Symbolen der Folie handelt es sich um Bediensymbole und/oder Anzeigesymbole, wobei ein Anzeigesymbol insbesondere oberhalb einer ersten Aussparung bzw. oberhalb einer Durchgangsöffnung oder ersten Vertiefung angeordnet ist.

Es besteht aber auch die Möglichkeit, die Oberfläche der Oberseite des Trägerelementes mit wenigstens einem Symbol zu bedrucken, was beispielsweise mittels Siebdruck oder Tampondruck erfolgen kann. Alternativ kann die Oberfläche der Oberseite des Trägerelementes zumindest teilweise beschichtet sein, wobei in die Beschichtung wenigstens ein Symbol eingearbeitet ist. Bei der Beschichtung kann es sich beispielsweise um einen lichtundurchlässigen Lack handeln, der zur Erzeugung des Symbols teilweise entfernt wird, wozu beispielsweise ein Laser verwendet werden kann.

Nach einer Variante der Erfindung ist ein Anzeigeelement der Anzeigeeinrichtung in einer ersten Vertiefung des Trägerelementes angeordnet, wobei der in Richtung auf die Oberseite des Trägerelementes gesehene Boden der ersten Vertiefung ein im Wesentlichen lichtdurchlässiges Material aufweist, wobei über dem Boden auf der Oberfläche der Oberseite des Trägerelementes ein Symbol angeordnet ist. Wenn also eine Durchgangsöffnung des Trägerelementes mit einem zweiten, im Wesentlichen lichtdurchlässigen Material verschlossen ist, kann auf dem Boden dieser ersten Vertiefung auf der Oberfläche der Oberseite des Trägerelementes ein Symbol aufgedruckt oder in eine Beschichtung eingebracht oder eine Folie mit einem Symbol angeordnet werden. Wird eine Folie mit Symbolen verwendet, ist es nicht unbedingt erforderlich, die Durchgangsöffnung mit einem lichtdurchlässigen Material zu versehen, da in diesem Fall das Symbol nicht auf die Oberfläche der Oberseite des Trägerelementes aufgedruckt bzw. in eine Beschichtung der Oberfläche eingebracht wird, sondern auf der Folie vorhanden ist.

Bei der Vorrichtung handelt es sich um eine Bedien- und Anzeigeeinheit, welche für den Herd vorgesehen und unter einer Glaskeramik des Herdes angeordnet ist.

Die Vorrichtung wird also als Bedien- und Anzeigeeinheit für den Herd verwendet. Die Vorrichtung kann jedoch auch für andere Haushaltsgeräte verwendet werden.

Ein Ausführungsbeispiel der Erfindung ist in den beigefügten schematischen Zeichnungen dargestellt. Es zeigen:
- FIG 1: in einer perspektivischen, auseinandergezogenen Darstellung eine Bedien- und Anzeigeeinheit für ein Haushaltsgerät mit einer Bedieneinrichtung, einem Trägerelement und einer Anzeigeeinrichtung;
- FIG 2: in einer geschnittenen Darstellung die Anordnung einer Bedien- und Anzeigeeinheit unter einer Glaskeramik eines Herdes und
- FIG 3: eine Draufsicht auf eine Bedien- und Anzeigeeinheit.

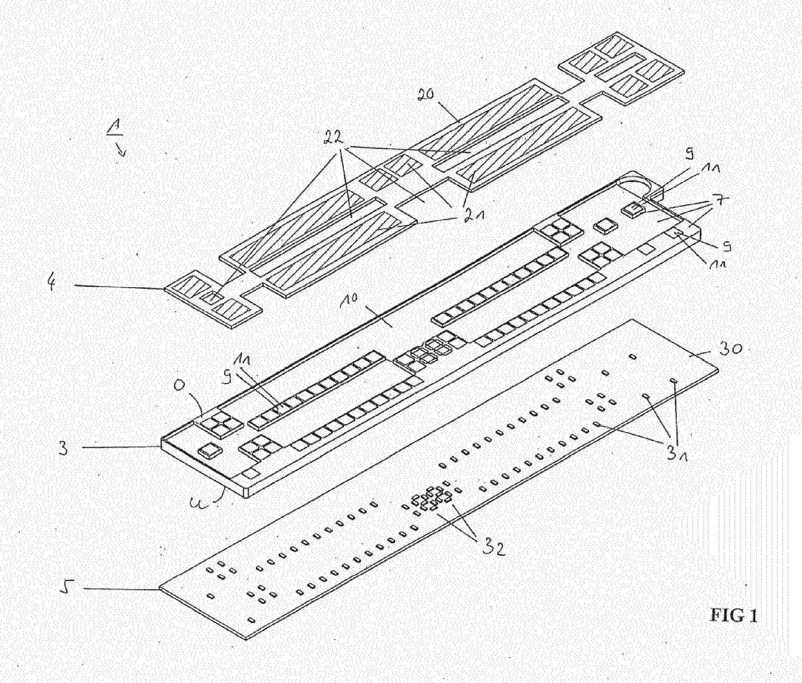

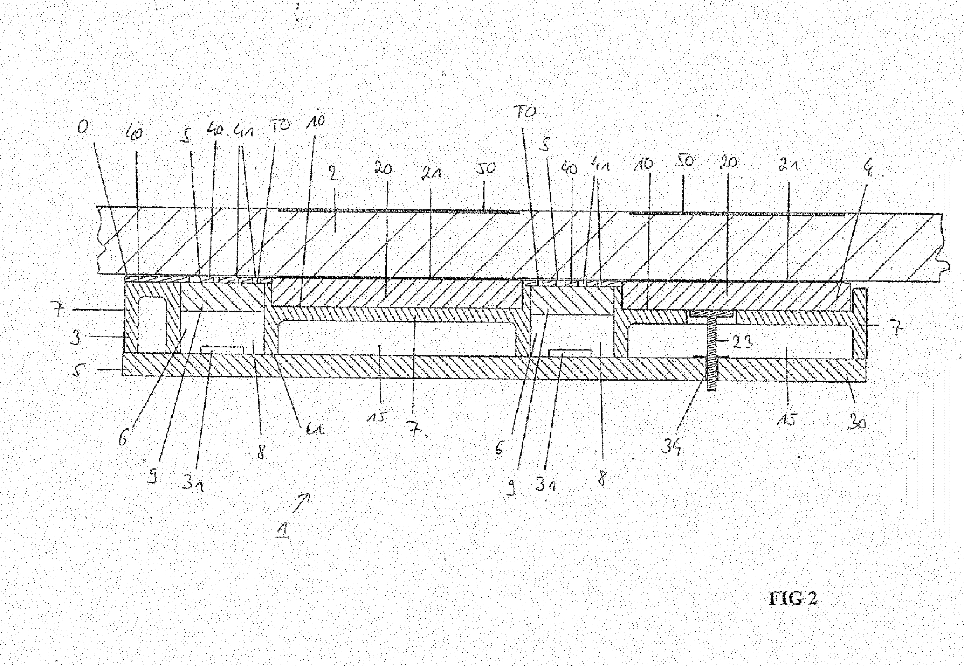

In FIG 1 ist in einer perspektivischen, auseinandergezogenen Darstellung eine erfindungsgemäße Vorrichtung für ein Haushaltsgerät in Form einer Bedien- und Anzeigeeinheit 1 gezeigt. Bei der Bedien- und Anzeigeeinheit 1 handelt es sich im Falle des vorliegenden Ausführungsbeispiels um eine Bedien- und Anzeigeeinheit 1 für einen Herd, wobei die Bedien- und Anzeigeeinheit 1, wie der FIG 2 zu entnehmen ist, zur Anordnung unterhalb einer Glaskeramik 2 eines Herdes vorgesehen ist.

Wie der FIG 1 entnommen werden kann, weist die Bedien- und Anzeigeeinheit 1 ein Trägerelement 3, eine Bedieneinrichtung 4 und eine Anzeigeeinrichtung 5 auf.

Das Trägerelement 3 ist ein Kunststoffformteil mit einer Oberseite O und einer Unterseite U. Wie insbesondere der FIG 2 zu entnehmen ist, weist das Trägerelement 3 auf der Unterseite U mehrere Ausnehmungen 15 und insbesondere mehrere erste Aussparungen bzw. erste Vertiefungen 6 auf. Das Trägerelement 3 ist im Falle des vorliegenden Ausführungsbeispiels aus zwei verschiedenen Kunststoffen ausgebildet, wobei der erste Kunststoff mit dem Bezugszeichen 7 versehen ist. Bei dem ersten Kunststoff 7 handelt es sich um einen, bevorzugt im Wesentlichen lichtundurchlässigen und/oder temperaturbeständigen Kunststoff. Insbesondere ist die Stärke bzw. die Dicke der Materialschicht des Kunststoffes derart gewählt, dass dieser lichtundurchlässig ist.

Die ersten Aussparungen bzw. ersten Vertiefungen 6 in dem Trägerelement 3 sind im Falle des vorliegenden Ausführungsbeispiels derart erzeugt, dass Durchgangsöffnungen 8 in dem ersten Kunststoff 7 des Trägerelementes 3 mit einem zweiten Kunststoff 9 einseitig verschlossen und im Falle des vorliegenden Ausführungsbeispiels zumindest teilweise ausgefüllt sind. Es wird also deutlich, dass das Trägerelement 3 im Falle des vorliegenden Ausführungsbeispiels aus einem ersten Kunststoff 7 und einem zweiten Kunststoff 9 ausgebildet ist, wobei Durchgangsöffnungen 8 im ersten Kunststoff 7 mittels eines zweiten Kunststoffes 9, welcher im Wesentlichen lichtdurchlässig ist, verschlossen sind. Der zweite Kunststoff 9 ist dabei jeweils derart in einer Durchgangsöffnung 8 angeordnet, dass sich auf der Oberseite O des Trägerelementes 3 im Bereich der Durchgangsöffnung 8 eine im Wesentlichen plane Teiloberfläche TO ergibt und auf der Unterseite U des Trägerelementes 3 eine erste Aussparung bzw. erste Vertiefung 6 ergibt. Bei dem zweiten Kunststoff 9 handelt es sich im Übrigen bevorzugt um einen lichtzerstreuenden Kunststoff, beispielsweise um ein Epoxidharz. Der zweite Kunststoff 9 ist insbesondere hinsichtlich seiner Schichtdicke bzw. Materialstärke derart in einer Durchgangsöffnung 8 ausgeführt, dass Licht in für eine Anzeige ausreichender Weise durch den zweiten Kunststoff 9 bzw. das Trägerelement 3 im Bereich der Durchgangsöffnung 8 bzw. der ersten Vertiefung 6 dringen kann.

Das Trägerelement 3 muss aber im Unterschied zu dem vorliegenden Ausführungsbeispiel nicht notwendigerweise aus zwei Kunststoffmaterialien ausgebildet sein. Vielmehr kann das Trägerelement 3 auch aus einem anderen, im Wesentlichen lichtundurchlässigen und/oder temperaturbeständigen ersten Material, beispielsweise einem Metall, ausgebildet sein. Auch bei dem zweiten Material muss es sich nicht notwendigerweise um einen Kunststoff handeln, vielmehr ist auch ein anderes, im Wesentlichen lichtdurchlässiges Material geeignet eine Durchgangsöffnung 8 einseitig zu verschließen und eine erste Vertiefung 6 auszubilden.

Bei dem Trägerelement 3 des vorliegenden Ausführungsbeispiels handelt es sich im Übrigen um ein Spritzgussteil, welches in einer entsprechenden Spritzgussmaschine bereits mit den zwei Kunststoffen hergestellt werden kann. Alternativ besteht die Möglichkeit, das Trägerelement 3 zunächst hinsichtlich des ersten Kunststoffmaterials zu erzeugen und die Durchgangsöffnungen 8 anschließend teilweise, beispielsweise mit einem Epoxidharz auszugießen, um die in FIG 2 dargestellten ersten Vertiefungen 6 zu erhalten.

In FIG 1 ist nochmals der Aufbau des Trägerelementes 3 hinsichtlich der zwei Kunststoffmaterialien erkennbar. Demnach ist das Trägerelement 3 im Falle des vorliegenden Ausführungsbeispiels im Wesentlichen aus dem lichtundurchlässigen Kunststoff 7 ausgebildet, welcher als eine Art Lichtmaske dient. Nur in den Bereichen, in denen die Durchgangsöffnungen 8 verschlossen wurden, liegt der lichtdurchlässige Kunststoff 9 vor, der in FIG 1 im Wesentlichen mit quadratischen Feldern 11 dargestellt ist, bei denen es sich quasi um Lichtfenster 11 handelt. Die Lichtfenster 11 müssen im Übrigen nicht notwendigerweise quadratisch sein, sondern können auch rund, oval, rechteckig sein oder eine andere Form aufweisen.

Wie insbesondere der FIG 1 entnommen werden kann, weist das Trägerelement 3 eine zweite Aussparung 10 in Form einer zweiten Vertiefung 10 auf seiner Oberseite O auf, welche derart ausgestaltet ist, dass sie die noch zu beschreibende Bedieneinrichtung 4 möglichst gut bzw. passgenau aufnehmen kann. Die Aufnahme der Bedieneinrichtung 4 in der zweiten Aussparung 10 auf der Oberseite O des Trägerelementes 3 ist in FIG 2 dargestellt. Die Bedieneinrichtung 4 ist vorliegend passgenau in der zweite Aussparung 10 des Trägerelementes 3 angeordnet. Die Bedieneinrichtung 4 weist eine Platine 20 auf, die mit Sensorflächen 21 versehen ist. Eine solche Sensorfläche 21 kann mit Kupfer versehen sein und/oder wenigstens einen kapazitiven Sensor, insbesondere einen kapazitiven Tastsensor als Bedienelement aufweisen. Ein Tastsensor kann beispielsweise ein Schalter oder eine Schieberegler sein. Die Tastsensoren können also verschiedenartig ausgeführt sein und sich funktionell unterscheiden. Die Platine 20 weist insbesondere dort Ausschnitte 22 auf, wo die den lichtdurchlässigen Kunststoff 9 aufweisenden Lichtfenster 11 des Trägerelementes 3 vorhanden sind, da dort in noch zu beschreibender Weise Licht aus der Bedien- und Anzeigeeinheit 1 austreten soll.

Die mit dem Bezugszeichen 5 versehene Anzeigeeinrichtung weist eine Platine 30 auf, auf der vorliegend eine Vielzahl von Leuchtelementen, im Falle des vorliegenden Ausführungsbeispiels LEDs 31, angeordnet sind. Etwa in der Mitte der Platine 30 bilden LEDs 31 dabei zwei Sieben-Segmentanzeigen 32. Die LEDs 31 sind im Falle des vorliegenden Ausführungsbeispiels derart auf der Platine 30 angeordnet, dass sie bei der Anordnung der Platine 30 an der Unterseite U des Trägerelementes 3 bevorzugt in einer erste Vertiefung 6 angeordnet werden. Die Anordnung der ersten Vertiefungen 6 des Trägerelementes 3 und die Anordnung der LEDs 31 auf der Platine 30 sind derart aufeinander abgestimmt, dass bevorzugt jeweils eine LED 31 in einer ersten Vertiefung 6 angeordnet wird, so dass von einer LED 31 ausgehendes Licht durch den lichtzerstreuenden Kunststoff 9 auf der Oberseite aus der Bedien- und Anzeigeeinheit 1 austreten kann. Auf der Unterseite der Platine 30 können im Übrigen in den FIG nicht dargestellter Weise weitere elektrotechnische Bauelemente, insbesondere weitere elektronische Bauelemente, angeordnet sein, welche über nichtgezeigte Leiterbahnen mit den LEDs 31, beispielsweise über Durchkontaktierungen, verbunden sind.

Die Bedieneinrichtung 4 und die Anzeigeeinrichtung 5 sind elektrisch miteinander verbunden, was beispielsweise über Folienleiter, Kabel, insbesondere Flexkabel, über Stiftleisten, welche miteinander verlötet, verpresst oder versteckt sind, bewerkstelligt sein kann. Im Falle des vorliegenden Ausführungsbeispiels ist an der Unterseite der Platine 20 der Bedieneinrichtung 4 ein Kontaktstift 23 angelötet, welcher mit einer Buchse 34 der Platine 30, bei der es sich um eine Kupferbuchse handelt, zur elektrischen Kontaktierung der Bedieneinrichtung 4 und der Anzeigeeinrichtung 5 miteinander zusammenwirkt. Die Bedien- und Anzeigeeinheit 1 kann mehrere derartige Kontaktstifte und Kontaktbuchsen aufweisen.

Wie der FIG 2 zu entnehmen ist, ist im Falle des vorliegenden Ausführungsbeispiels die Oberseite O des Trägerelementes 3, insbesondere die Oberfläche der Oberseite O des Trägerelementes 3 außerhalb der zweiten Aussparung 10 mit einem lichtundurchlässigen Lack 40 beschichtet. Oberhalb einer ersten Vertiefung 6, also über dem Boden einer ersten Vertiefung 6, ist auf der Oberfläche der Oberseite O des Trägerelementes 3 ein Symbol S eingearbeitet, was in FIG 2 durch Entfernung des Lackes 40 veranschaulicht ist. Im Falle des vorliegenden Ausführungsbeispiels sind die Lücken 41 in dem Lack 40 mit Hilfe eines Lasers eingebracht worden. Auf diese Weise kann jeweils oberhalb einer ersten Vertiefung 6 auf der Oberfläche der Oberseite O des Trägerelementes 3 in entsprechender Weise ein gewünschtes Symbol erzeugt werden, welches ein Bediener bei Aufleuchten einer LED 31 erkennen kann. Auf diese Weise können also die Lichtfenster 11 des Trägerelementes 3 jeweils mit einem entsprechenden Anzeigesymbol zur Anzeige unter anderem von Betriebszuständen und Betriebsparametern des Haushaltsgerätes versehen werden.

Derartige Symbole müssen aber nicht notwendigerweise aus einer Beschichtung 40 herausgearbeitet werden. Vielmehr besteht auch die Möglichkeit die Oberseite eines Bodens einer ersten Vertiefung 6, also die Oberfläche der Oberseite O des Trägerelementes 3 mit einem Symbol zu bedrucken. Hierfür kann beispielsweise Siebdruck oder Tampondruck verwendet werden. Auch auf diese Weise lassen sich ausleuchtbare Symbole oberhalb einer ersten Vertiefung 6 erhalten.

Alternativ kann auch in den FIG nicht dargestellter Weise auf der Oberseite O des Trägerelementes 3 eine wenigstens ein Symbol, in der Regel mehrere Symbole, aufweisende Folie angeordnet, z. B. aufgeklebt werden, wobei die Folie derart auf dem Trägerelement 3 angeordnet wird, dass sich die vorgesehenen Symbole jeweils über einem Lichtfenster 11 befinden. Bevorzugt ist die Folie nur im Bereich der Symbole lichtdurchlässig. Die Symbole können dabei beispielsweise aus der Folie ausgestanzt sein oder die Folie weist zur Ausbildung der Symbole beispielsweise Schwärzungen auf, so dass bei Beleuchtung der Folie die Symbole zu erkennen sind. Bei Verwendung einer derartigen Symbole aufweisenden Folie, kann im Übrigen ggf. in Abweichung von dem bisher beschriebenen Ausführungsbeispiel, auf den zweiten Kunststoff 9, welcher die Durchgangsöffnungen 8 verschließt, verzichtet werden, da in diesem Fall keine Beschichtung bzw. Bedruckung des zweiten Kunststoffs 9 vorgesehen bzw. erfolgt ist. Der zweite Kunststoff 9 kann jedoch auch dann vorgesehen sein, wenn damit bewirkt werden soll, dass das von einer LED 31 ausgehende Licht diffus gestreut werden soll, um damit das Symbol besser auszuleuchten. Der zweite Kunststoff hat also auch die Funktion eines Diffusors.

In den FIG nicht dargestellter Weise sind das Trägerelement 3, die Bedieneinrichtung 4 und die Anzeigeeinrichtung 5 derart miteinander verbunden, dass sie eine Einheit bilden. Die Verbindung kann dabei eine lösbare, aber auch eine nichtlösbare Verbindung sein. Als lösbare Verbindung ist beispielsweise eine Rastverbindung mit Rasthaken oder eine Schraubenverbindung möglich. Eine nichtlösbare Verbindung stellt das Ultraschallverschweißen sowie das Verkleben des Trägerelementes 3, der Bedieneinrichtung 4 und der Anzeigeeinrichtung 5 dar.

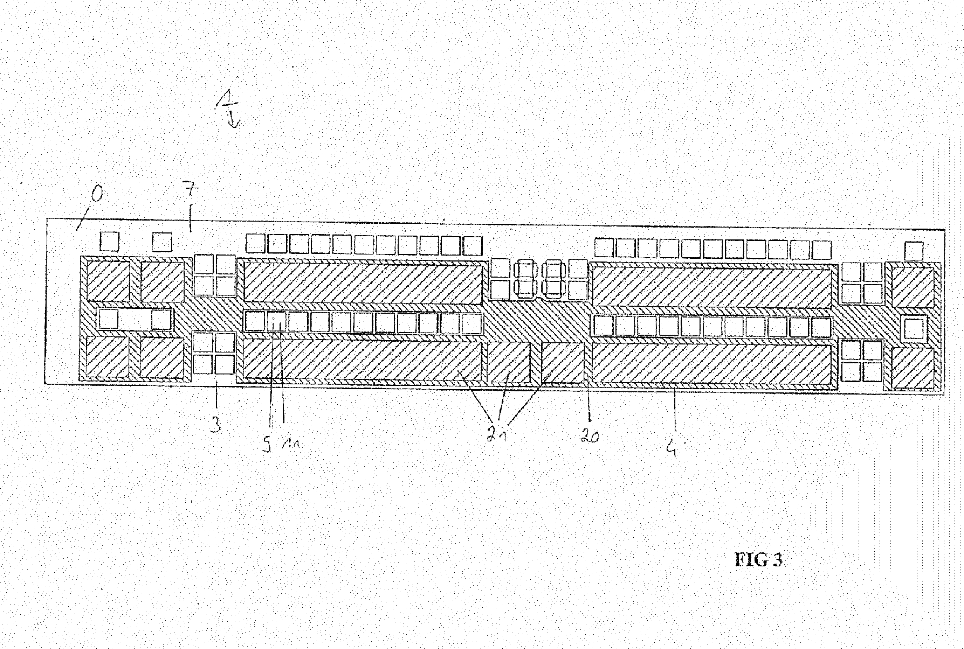

Die FIG 3 zeigt ergänzend nochmals eine Ansicht der Bedien- und Anzeigeeinheit 1 von oben, wobei die den Lichtfeldern 11 zugeordneten Symbole nicht gezeigt sind.

Wie bereits erwähnt ist die Bedien- und Anzeigeeinheit 1 im Falle des vorliegenden Ausführungsbeispiels für einen in seiner Gesamtheit nicht dargestellten Herd vorgesehen, wobei, wie aus FIG 2 zu erkennen ist, die Bedien- und Anzeigeeinheit 1 direkt unterhalb einer Glaskeramik 2 des Herdes angeordnet ist. Die Bedien- und Anzeigeeinheit 1 kann unter die Glaskeramik 2 gepresst oder unter die Glaskeramik 2 geklebt sein. Die Anordnung der Bedien- und Anzeigeeinheit 1 nur unter Druck an der Glaskeramik 2 hat Vorteile bei einem eventuell erforderlichen Austausch der Bedien- und Anzeigeeinheit 1 oder einer Komponente der Bedien- und Anzeigeeinheit 1. Bei einer defekten Komponente oder einer defekten Bedien- und Anzeigeeinheit 1 an sich muss die Glaskeramik nicht mit ausgetauscht werden. Vielmehr kann nur die defekte Komponente der Bedien- und Anzeigeeinheit 1 oder die Bedien- und Anzeigeeinheit 1 an sich ausgetauscht werden. Entsprechendes gilt bei einer defekten Glaskeramik. In diesem Fall kann nur die Glaskeramik ausgetauscht werden.

Auf der Oberseite der Glaskeramik 2 befinden sich Bedruckungen 50, die den Benutzer auf die Bedienelemente der Bedien- und Anzeigeeinheit 1 hinweisen. Der Benutzer kann demnach beispielsweise mittels der kapazitiven Sensoren den Herd bedienen, wobei je nach Eingaben des Bedieners und Betriebszustandes des Herdes unterschiedliche LEDs 31 aufleuchten und Betriebszustände über die erwähnten Symbole S sowie die Sieben-Segmentanzeigen 32 dem Bediener anzeigen.

Die Bedien- und Anzeigeeinheit 1 ist im Übrigen in nicht dargestellter Weise mit einer Steuerung des Herdes verbunden, welche die Bedieneingaben des Bedieners entsprechend auswertet, verarbeitet und unter anderem für die Ansteuerung der Anzeigeelemente der Anzeigeeinrichtung 5 sorgt. Die Bedien- und Anzeigeeinheit 1 kann aber auch selbst steuernde Bauelemente aufweisen.

Die Bedien- und Anzeigeeinrichtung wurde vorstehend am Beispiel einer Bedien- und Anzeigeeinrichtung 1 für einen Herd beschrieben. Die Bedien- und Anzeigeeinrichtung ist jedoch auch bei anderen Haushaltsgeräten einsetzbar. Beispielsweise kann auch eine Waschmaschine oder ein Trockner mit einer derartigen Bedieneinrichtung versehen sein.

Die erfindungsgemäße Vorrichtung bzw. die erfindungsgemäße Bedien- und Anzeigeeinheit zeichnet sich durch einen einfachen, modularen, robusten und kompakten Aufbau aus, wodurch die Bedien- und Anzeigeeinheit auch einfach zu montieren ist.

### Bezugszeichenliste

- 1: Bedien- und Anzeigeeinheit
- 2: Glaskeramik
- 3: Trägerelement
- 4: Bedieneinrichtung
- 5: Anzeigeeinrichtung
- 6: erste Aussparung bzw. erste Vertiefung
- 7: erster Kunststoff
- 8: Durchgangsöffnung
- 9: zweiter Kunststoff
- 10: zweite Aussparung bzw. zweite Vertiefung
- 11: quadratische Felder bzw. Lichtfenster
- 15: Ausnehmung
- 20: Platine der Bedieneinrichtung
- 21: Sensorflächen
- 22: Ausschnitte
- 23: Kontaktstift
- 30: Platine der Anzeigeeinrichtung
- 31: LED
- 32: Sieben-Segmentanzeige
- 34: Kontaktbuchse
- 40: Lack
- 41: Lücken
- 50: Bedruckung

- O: Oberseite
- U: Unterseite
- TO: Teiloberfläche
- S: Symbol

## Patentansprüche

1. Herd mit einer Bedien- und Anzeigeeinheit (1), die unter einer Glaskeramik (2) des Herdes angeordnet ist, wobei die Bedien- und Anzeigeeinheit (1) umfasst:
- ein eine Oberseite (0) und eine Unterseite (U) umfassendes und als Kunststoffformteil ausgebildetes Trägerelement (3),
- eine wenigstens ein Bedienelement (21) und eine das wenigstens eine Bedienelement (21) umfassende erste Platine (20) aufweisende Bedieneinrichtung (4) und
- eine wenigstens ein Anzeigeelement (31, 32) und eine das wenigstens eine Anzeigeelement (31, 32) umfassende zweite Platine (30) aufweisende Anzeigeeinrichtung (5),
- wobei das Trägerelement (3) auf seiner Unterseite (U) wenigstens eine erste Aussparung (6, 8) aufweist,
- wobei die Bedieneinrichtung (4) auf der Oberseite (0) des Trägerelementes (3) und die Anzeigeeinrichtung (5) zumindest teilweise in der ersten Aussparung (6, 8) auf der Unterseite (U) des Trägerelementes (3) angeordnet ist,
wobei das Trägerelement (3) auf seiner Oberseite (0) wenigstens eine zweite Aussparung (10) aufweist, wobei die Bedieneinrichtung (4) zumindest teilweise in der zweiten Aussparung (10) auf der Oberseite (0) des Trägerelementes (3) angeordnet ist.

2. Herd nach Anspruch 1, bei der das Trägerelement (3) ein im Wesentlichen lichtundurchlässiges und/oder temperaturbeständiges erstes Material (7) aufweist.

3. Herd nach Anspruch 1 oder 2, bei der das Trägerelement (3) ein zweites im Wesentlichen lichtdurchlässigen Material (9) aufweist.

4. Herd nach einem der Ansprüche 1 bis 3, bei der die erste Aussparung des Trägerelement als Durchgangsöffnung (8) oder erste Vertiefung (6) auf der Unterseite (U) des Trägerelementes (3) ausgebildet ist, wobei vorzugsweise zum Erhalt der ersten Vertiefung (6) auf der Unterseite (U) des Trägerelementes (3) die Durchgangsöffnung (8) mit dem zweiten Material (9) verschlossen und/oder zumindest teilweise ausgefüllt ist.

5. Herd nach Anspruch 4, bei der die Durchgangsöffnung (8) zur Bildung der ersten Vertiefung (6) derart mit dem zweiten Material (9) verschlossen und/oder zumindest teilweise ausgefüllt ist, dass sich auf der Oberseite (O) des Trägerelementes (3) im Bereich der Durchgangsöffnung (8) eine im Wesentlichen plane Teiloberfläche (TO) und dass sich auf der Unterseite (U) des Trägerelementes (3) die erste Vertiefung (6) ergibt.

6. Herd nach einem der Ansprüche 2 bis 5, bei der das erste und/oder das zweite Material ein Kunststoff ist.

7. Herd nach einem der Ansprüche 3 bis 6, bei der das zweite Material (9) ein lichtzerstreuendes Material oder ein lichtzerstreuender Kunststoff oder ein Epoxidharz ist.

8. Herd nach einem der Ansprüche 1 bis 7, bei der die Platine (20) wenigstens eine Leiterbahn und/oder wenigstens eine Kupferfläche (21) aufweist.

9. Herd nach einem der Ansprüche 1 bis 8, bei der die Bedieneinrichtung (4) als Bedienelement wenigstens einen Sensor aufweist, wobei vorzugsweise der Sensor ein kapazitiver Sensor oder ein kapazitiver Tastsensor ist.

10. Herd nach einem der Ansprüche 1 bis 9, bei der die Platine (30) wenigstens eine Leiterbahn aufweist.

11. Herd nach einem der Ansprüche 1 bis 10, bei der ein Anzeigeelement ein Leuchtelement oder eine LED (Light Emitting Diode) (31) oder eine Sieben-Segmentanzeige (32) ist.

12. Herd nach einem der Ansprüche 1 bis 11, bei der die Anzeigeeinrichtung (5) und die Bedieneinrichtung (4) miteinander elektrisch verbunden sind, wobei vorzugsweise die Anzeigeeinrichtung (5) und die Bedieneinrichtung (4) über wenigstens einen Folienleiter oder wenigstens eine Kontaktbuchse (34) und wenigstens einen Kontaktstift (23) miteinander elektrisch verbunden sind.

13. Herd nach einem der Ansprüche 1 bis 12, bei der das Trägerelement (3), die Bedieneinrichtung (4) und die Anzeigeeinrichtung (5) eine Einheit (1) bilden, wobei vorzugsweise das Trägerelement (3), die Bedieneinrichtung (4) und die Anzeigeeinrichtung (5) mittels Rastverbindung und/oder Ultraschallverschweißen und/oder Verkleben miteinander zu einer Einheit (1) verbunden sind.

14. Herd nach einem der Ansprüche 1 bis 13, bei der auf der Oberseite (O) des Trägerelementes (3) und/oder der Bedieneinrichtung (4) eine wenigstens ein Symbol aufweisende Folie angeordnet ist.

15. Herd nach einem der Ansprüche 1 bis 14, bei der die Oberfläche der Oberseite (0) des Trägerelementes (3) mit wenigstens einem Symbol bedruckt ist, wobei vorzugsweise die Bedruckung mittels Siebdruck oder Tampondruck erfolgt.

16. Herd nach einem der Ansprüche 1 bis 15, bei der die Oberfläche der Oberseite (0) des Trägerelementes (3) zumindest teilweise beschichtet ist, wobei in die Beschichtung (40) wenigstens ein Symbol (S) eingearbeitet ist, und wobei vorzugsweise die Oberfläche mit einem lichtundurchlässigen Lack (40) versehen ist.

17. Herd nach Anspruch 16, bei der das Symbol (S) durch teilweises Entfernen der Beschichtung (40) erhalten ist, wobei vorzugsweise die Entfernung der Beschichtung (40) mittels eines Lasers erfolgt.

18. Herd nach einem der Ansprüche 14 bis 17, bei der ein Anzeigeelement (31) der Anzeigeeinrichtung (5) in einer ersten Vertiefung (6) des Trägerelementes (3) angeordnet ist, wobei der in Richtung auf die Oberseite (O) des Trägerelementes (3) gesehene Boden der ersten Vertiefung (6) ein im Wesentlichen lichtdurchlässiges Material (9) aufweist, wobei über dem Boden auf der Oberfläche der Oberseite (0) des Trägerelementes (3) ein Symbol (S) angeordnet ist, und wobei vorzugsweise ein Anzeigeelement (31) der Anzeigeeinrichtung (5) in einer Durchgangsöffnung (8) des Trägerelementes (3) angeordnet ist, wobei über der Durchgangsöffnung (8) auf der Oberseite (O) des Trägerelementes (3) ein Symbol auf einer Folie angeordnet ist.

## Claims

1. Cooker with an operator control and display unit (1), which is arranged under a glass ceramic (2) of the oven, wherein the operator control and display unit (1) comprises:
- a carrier element (3) comprising an upper side (O) and an underside (U) and formed as a plastic moulding,
- an operator control device (4), comprising at least one operator control element (21) and a first printed circuit board (20) comprising the at least one operator control element (21), and
- a display device (5), having at least one display element (31, 32) and a second printed circuit board (30) comprising the at least one display element (31, 32),
- wherein the carrier element (3) has at least a first clearance (6, 8) on its underside (U),
- wherein the operator control device (4) is arranged on the upper side (O) of the carrier element (3) and the display device (5) is at least partially arranged in the first clearance (6, 8) on the underside (U) of the carrier element (3),
wherein the carrier element (3) has at least a second clearance (3) on its upper side (O), wherein the operator control device (4) is at least partially arranged in the second clearance (10) on the upper side (O) of the carrier element (3).

2. Oven according to Claim 1, in which the carrier element (3) comprises a substantially opaque and/or temperature-resistant first material (7).

3. Oven according to Claim 1 or 2, in which the carrier element (3) comprises a second substantially translucent material (9).

4. Oven according to one of Claims 1 to 3, in which the first clearance of the carrier material is formed as a through-opening (8) or a first recess (6) on the underside (U) of the carrier element (3), wherein preferably, to obtain the first recess (6) on the underside (U) of the carrier element (3), the through-opening (8) is closed and/or at least partially filled with the second material (9).

5. Oven according to Claim 4, in which, to form the first recess (6), the through-opening (8) is closed and/or at least partially filled with the second material (9) in such a way that a substantially planar subsurface (TO) is obtained on the upper side (O) of the carrier element (3) in the region of the through-opening (8) and that the first recess (6) is obtained on the underside (U) of the carrier element (3).

6. Oven according to one of Claims 2 to 5, in which the first and/or the second material is a plastic.

7. Oven according to one of Claims 3 to 6, in which the second material (9) is a light-scattering material or a light-scattering plastic or an epoxy resin.

8. Oven according to one of Claims 1 to 7, in which the printed circuit board (20) has at least one conductor track and/or at least one copper area (21).

9. Oven according to one of Claims 1 to 8, in which the operator control device (4) has as an operator control element at least one sensor, wherein preferably the sensor is a capacitive sensor or a capacitive touch sensor.

10. Oven according to one of Claims 1 to 9, in which the printed circuit board (30) has at least one conductor track.

11. Oven according to one of Claims 1 to 10, in which a display element is an illuminating element or an LED (light-emitting diode) (31) or a seven-segment display (32).

12. Oven according to one of Claims 1 to 11, in which the display device (5) and the operator control device (4) are electrically connected to one another, wherein preferably the display device (5) and the operator control device (4) are electrically connected to one another by way of at least one foil conductor or at least one contact socket (34) and at least one contact pin (23).

13. Oven according to one of Claims 1 to 12, in which the carrier element (3), the operator control device (4) and the display device (5) form a unit (1), wherein preferably the carrier element (3), the operator control device (4) and the display device (5) are connected to one another to form a unit (1) by means of a latching connection and/or ultrasonic welding and/or adhesive bonding.

14. Oven according to one of Claims 1 to 13, in which a foil having at least one symbol is arranged on the upper side (O) of the carrier element (3) and/or the operator control device (4).

15. Oven according to one of Claims 1 to 14, in which the surface of the upper side (O) of the carrier element (3) is printed with at least one symbol, wherein preferably the printing is performed by means of screen printing or pad printing.

16. Oven according to one of Claims 1 to 15, in which the surface of the upper side (O) of the carrier element (3) is at least partially coated, wherein at least one symbol (S) is incorporated in the coating (40), and wherein preferably the surface is provided with an opaque lacquer (40).

17. Oven according to Claim 16, in which the symbol (S) is obtained by partially removing the coating (40), wherein preferably the removal of the coating (40) is performed by means of a laser.

18. Oven according to one of Claims 14 to 17, in which a display element (31) of the display device (5) is arranged in a first recess (6) of the carrier element (3), wherein the base of the first recess (6) as seen in the direction of the upper side (O) of the carrier element (3) comprises a substantially translucent material (9), wherein a symbol (S) is arranged over the base on the surface of the upper side (O) of the carrier element (3), and wherein preferably a display element (31) of the display device (5) is arranged in a through-opening (8) of the carrier element (3), wherein a symbol is arranged on a foil over the through-opening (8) on the upper side (O) of the carrier element (3).

## Revendications

1. Plaque de cuisson pourvue d'une unité de commande et d'affichage (1) qui est disposée au-dessous d'une vitrocéramique (2) de la plaque de cuisson, l'unité de commande et d'affichage (1) comprenant :
- un élément de support (3) comprenant une face supérieure (O) et une face inférieure (U) et réalisé sous la forme d'une pièce en matière plastique,
- un dispositif de commande (4) présentant au moins un élément de commande (21) et une première platine (20) comprenant ledit au moins un élément de commande (21), et
- un dispositif d'affichage (5) présentant au moins un élément d'affichage (31, 32) et une deuxième platine (30) comprenant ledit au moins un élément d'affichage (31, 32),
- l'élément de support (3) présentant sur sa face inférieure (U) au moins un premier évidement (6, 8),
- le dispositif de commande (4) étant disposé sur la face supérieure (O) de l'élément de support (3) et le dispositif d'affichage (5) étant disposé au moins partiellement dans le premier évidement (6, 8) sur la face inférieure (U) de l'élément de support (3),
l'élément de support (3) présentant sur sa face supérieure (O) au moins un deuxième évidement (10), le dispositif de commande (4) étant disposé au moins partiellement dans le deuxième évidement (10) sur la face supérieure (O) de l'élément de support (3).

2. Plaque de cuisson selon la revendication 1, dans laquelle l'élément de support (3) présente un premier matériau (7) substantiellement opaque et/ou résistant à la chaleur.

3. Plaque de cuisson selon la revendication 1 ou 2, dans laquelle l'élément de support (3) présente un deuxième matériau (9) substantiellement opaque.

4. Plaque de cuisson selon l'une quelconque des revendications 1 à 3, dans laquelle le premier évidement de l'élément de support est réalisé sous la forme d'une ouverture de passage (8) ou d'un premier creux (6) sur la face inférieure (U) de l'élément de support (3), dans laquelle, de préférence pour obtenir le premier creux (6), sur la face inférieure (U) de l'élément de support (3), l'ouverture de passage (8) est fermée et/ou remplie au moins partiellement avec le deuxième matériau (9).

5. Plaque de cuisson selon la revendication 4, dans laquelle, pour former le premier creux (6), l'ouverture de passage (8) est fermée et/ou remplie au moins partiellement avec le deuxième matériau (9) qu'il en résulte une surface partielle (TO) substantiellement plane sur la face supérieure (O) de l'élément de support (3) au niveau de l'ouverture de passage (8), et en ce qu'il en résulte le premier creux (6) sur la face inférieure (U) de l'élément de support (3).

6. Plaque de cuisson selon l'une quelconque des revendications 2 à 5, dans laquelle le premier et/ou le deuxième matériau est une matière plastique.

7. Plaque de cuisson selon l'une quelconque des revendications 3 à 6, dans laquelle le deuxième matériau (9) est un matériau dispersant la lumière ou une matière plastique dispersant la lumière ou une résine époxy.

8. Plaque de cuisson selon l'une quelconque des revendications 1 à 7, dans laquelle la platine (20) présente au moins une piste conductive et/ou au moins une surface de cuivre (21).

9. Plaque de cuisson selon l'une quelconque des revendications 1 à 8, dans laquelle le dispositif de commande (4) présente au moins un capteur comme élément de commande, le capteur étant de préférence un capteur capacitif ou un palpeur capacitif.

10. Plaque de cuisson selon l'une quelconque des revendications 1 à 9, dans laquelle la platine (30) présente au moins une piste conductive.

11. Plaque de cuisson selon l'une quelconque des revendications 1 à 10, dans laquelle un élément d'affichage est un élément lumineux ou une DEL (diode électroluminescente) (31) ou affichage à sept segments (32) .

12. Plaque de cuisson selon l'une quelconque des revendications 1 à 11, dans laquelle le dispositif d'affichage (5) et le dispositif de commande (4) sont reliés électriquement l'un à l'autre, le dispositif d'affichage (5) et le dispositif de commande (4) étant de préférence reliés électriquement l'un à l'autre par au moins un conducteur plat ou au moins une douille de contact (34) et au moins une fiche de contact (23).

13. Plaque de cuisson selon l'une quelconque des revendications 1 à 12, dans laquelle l'élément de support (3), le dispositif de commande (4) et le dispositif d'affichage (5) forment une unité (1), dans laquelle de préférence l'élément de support (3), le dispositif de commande (4) et le dispositif d'affichage (5) sont reliés les uns aux autres au moyen d'un assemblage par enclenchement et/ou par soudage par ultrasons et/ou par collage pour former une unité (1).

14. Plaque de cuisson selon l'une quelconque des revendications 1 à 13, dans laquelle une pellicule présentant au moins un symbole est disposée sur la face supérieure (O) de l'élément de support (3) et/ou du dispositif de commande (4).

15. Plaque de cuisson selon l'une quelconque des revendications 1 à 14, dans laquelle au moins un symbole est imprimé sur la surface de la face supérieure (O) de l'élément de support (3), l'impression étant de préférence effectuée par sérigraphie ou par tampographie.

16. Plaque de cuisson selon l'une quelconque des revendications 1 à 15, dans laquelle la surface de la face supérieure (O) de l'élément de support (3) est au moins partiellement revêtue, au moins un symbole (S) étant incorporé dans le revêtement (40), et la surface étant de préférence pourvue d'un vernis opaque (40).

17. Plaque de cuisson selon la revendication 16, dans laquelle le symbole (S) est obtenu par retrait partiel du revêtement (40), le retrait du revêtement (40) étant effectué de préférence au moyen d'un laser.

18. Plaque de cuisson selon l'une quelconque des revendications 14 à 17, dans laquelle un élément d'affichage (31) du dispositif d'affichage (5) est disposé dans un premier creux (6) de l'élément de support (3), dans laquelle le fond du premier creux (6), vu en direction de la face supérieure (O) de l'élément de support (3), présente un matériau substantiellement opaque (9), un symbole (S) étant disposé au-dessus du fond sur la surface de la face supérieure (O) de l'élément de support (3), et dans laquelle de préférence un élément d'affichage (31) du dispositif d'affichage (5) est disposé dans une ouverture de passage (8) de l'élément de support (3), un symbole étant disposé sur une pellicule au-dessus de l'ouverture de passage (8) sur la face supérieure (O) de l'élément de support (3).
